# EUROPEAN PATENT SPECIFICATION

(11) **EP 4 403 871 B1**
(45) Date of publication and mention of the grant of the patent: **17.09.2025**
(21) Application number: 23305074.9
(22) Date of filing: 23.01.2023
(51) Int. Cl.: G01B 7/16, G01L 1/22, G01M 5/00, H05K 1/02

(54) **MECHANICAL FATIGUE MONITORING FOR POWER MODULE PACKAGING**
MECHANISCHE ERMÜDUNGSÜBERWACHUNG FÜR LEISTUNGSMODULVERPACKUNG
SURVEILLANCE DE FATIGUE MÉCANIQUE POUR BOÎTIER DE MODULE DE PUISSANCE

(43) Date of publication of application: 24.07.2024
(73) Proprietor: Mitsubishi Electric R&D Centre Europe B.V., 1119 NS Schiphol Rijk Amsterdam (NL); MITSUBISHI ELECTRIC CORPORATION, Chiyoda-ku Tokyo 100-8310 (JP)
(72) Inventor: PERRIN, Rémi, 35708 RENNES CÉDEX 7 (FR)
(74) Representative: Plasseraud IP

(56) References cited:
- EP-A1- 1 708 554
- EP-A1- 3 430 643
- EP-A1- 3 481 161
- US-A1- 2006 021 453
- US-A1- 2010 236 334
- US-A1- 2021 396 606
- HOLOGNE-CARPENTIER MALORIE ET AL: "A multi-physics approach to condition monitoring of SiC power module", MICROELECTRONIC ENGINEERING, vol. 250, 1 October 2021 (2021-10-01), NL, pages 111633, XP093053519, ISSN: 0167-9317, DOI: 10.1016/j.mee.2021.111633

## Description

### Technical Field

The present disclosure pertains to the field of monitoring the degradation of electronic power module using integrated power board (IPB) technology which are subject to thermal stress and in particular the field of monitoring mechanical fatigue of power modules packaging.

### Background Art

For power module using integrated power board technology where a PCB embeds components, one of the challenges to address is the compatibility between each material used in the PCB stack. Copper, epoxy, silicon and more generally all the constitutive elements have different thermal expansion coefficient (CTE) which creates mechanical stress under thermal cycling.

From the manufacturing to the end of life of the PCB, embedded power modules are facing thermal shock, thermal stress during cycling and mechanical constrains. The PCB deformation and flexibility due to its mechanical properties is one of the main causes of the aging of PCB power modules which results mainly in delamination of the PCB among other defects such as short circuits of the die, cracks on conductive paths or other.

In this regard, document US2010/236334 A1 concerns providing a strain gauge made using multiple layers in an integrated circuit die, document US 2021/396606 A1 describes a PCB equipped with external components soldered on the surface of the PCB and comprising strain gauges mounted on external surface of the PCB and EP 3 481 161 A1 describes a component carrier comprising a stack of electrically conductive layers and insulating layers in which electronic components are embedded. Also, documents EP 1 708 554 A1 concerns a multilayer printed wiring board receiving electronic components on an upper surface and having at least one strain gauge embedded in an inner layer of the wiring board, US2006/021453 A1 concerns a multilayer PCB receiving on its surface electronic components and at least one strain gauge, EP 3 430 643 A1 describes a component carrier comprising an interconnected stack of conductive and insulating layers, one of the conductive layers comprising an embedded strain gauge. Document Hologne-Carpentier Malorie ET AL "A multi-physics approach to condition monitoring of SiC power module" XP093053519 concerns a stress measurement method for a SiC where a strain gauge is attached on a surface of said SiC.

### Summary

In view of this problem, the present disclosure aims to solve the lack of monitoring capability during the operational life of a PCB embedded power module and proposes to incorporate one or more strain gauges in such PCB to provide self-monitoring, end-of-life prognostic and production debugging capabilities of such PCBs.

More precisely, the present disclosure proposes a power module according to claim 1.

The deformation sensing elements provide a means to compute the result of deformation cycles of the PCB and to provide an estimate of time before failure of such PCB.

In possible embodiments:
The power module may comprise at least one of said sensing elements in the vicinity of said one or more power dies to detect mechanical deformation due to temperature cycling of said die.

This gives an accurate detection of deformation of the PCB at a die location.

The power module may comprise at least one of said sensing elements at in a corner area of said PCB, said sensing element being adapted to provide a measure of mechanical flatness defects of said PCB upon mounting of said PCB on a heatsink.

This provides a measurement of the stress of the PCB when mounted on a heatsink.

At least one of said sensing elements may be designed as a frame in said PCB and adapted to provide a measure of mechanical flatness defects of said PCB upon mounting of said PCB on a heatsink.

At least one of said sensing elements may be made with metallic tracks structured in a copper layer of the top or bottom side of said core layer of said PCB.

Said one or more sensing elements may be made of additional parts glued on the top or the bottom side of said core layer in a copper free area of said top or bottom side of said core layer.

The power module may comprise two or more power semiconductor dies and may comprise a sensing element for each of said power semiconductor dies.

At least one of said sensing elements may comprise a strain gauge arrangement comprising resistance patterns designed to form an indicator of the mechanical effort in the vicinity of the strain gauge arrangement, irrespective of the direction of such mechanical effort in said three dimension coordinate system attached to the PCB.

Said one or more sensing elements may have connections made of vias and tracks on said PCB.

Said one or more sensing elements may be strain gauges incorporated in Wheatstone bridges having a differential output V_{CH} connected to a controller chip through an amplifier, and an analog to digital converter.

The present disclosure also concerns a process for measuring stress on a power module PCB according to the disclosure and comprising:
a. - an initial measurement of a deformation D₀ of the PCB in use during a calibration period with said strain gauges to provide a calibration of an initial deformation range of said PCB,
b. - in use measurements of deformation cycles Cy of said PCB and counting of said deformation cycles,
c. - repeating said in use measurements during operation of said power module.

The process may comprise measurement of plastic deformation of said PCB through comparison of the minimum and maximum deformation of said PCB during operation of the power module with the initial deformation range.

For a power module comprising two or more power semiconductors wherein said power module comprises a strain gauge for each die of said power semiconductors, the process may comprise a comparison of deformation at a location of each of said dies and a generation of a feedback signal to a controller driving gate drivers of said power semi-conductors to provide an adaptative gate control or count of abnormal unbalanced cases in case of uneven deformations of the PCB at said locations.

The process may also comprise providing deformation measurement data to a lifetime model of said PCB to provide lifetime model predictions for predictive maintenance.

### Brief Description of the Drawings

Other features, details and advantages will be shown in the following detailed description and on the attached drawings where:
Figure 1 shows a perspective view of thermal deformation of a PCB around a power semiconductor die;
Figure 2 shows part of a power module with embedded die;
Figure 3 shows part of a power module with embedded die comprising a strain gauge according to a first embodiment;
Figure 4 shows a first example of a power module with embedded die comprising strain gauges;
Figure 5 shows a second example of a power module with embedded die comprising strain gauges;
Figures 6 shows a simplified schematics of PCB deformation detector with strain gauge;
Figure 7 shows part of a power module with embedded die comprising a strain gauge according to a second embodiment;
Figure 8 shows a flowchart of steps of a process of the present disclosure;
Figure 9 shows a simplified schematics of a multiple gauge detection process;
Figure 10 shows a possible strain gauge arrangement.

### Description of Embodiments

Power modules packages based on integrated power board technology comprising a PCB in which at least a power die is embedded. Different power dies often have differences in terms of intrinsic characteristics which lead to switching and thermal behaviour differences. Also, different locations of the dies in the packages can also affect the thermal behaviour of the dies and packages causing deformations in the PCBs that could lead to delamination cracks in solder joints or vias and result in failure of the modules.

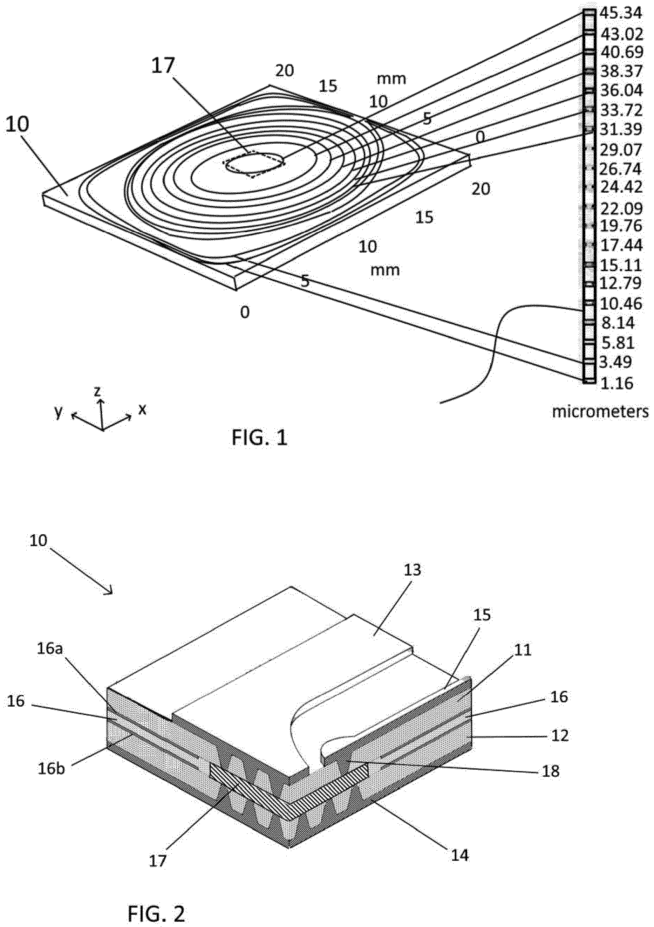

Figure 1 illustrates deformations of a sample of 20 by 20 mm with 4 levels of vias in between each copper layer and one die 17 in the centre. In the simulation each corner is constrained as if the sample was screwed on a support. A water-cooling system is applied on the bottom part 8000 W.m/°C, adiabatic on the edge and natural convection on the top of the sample 15 W.m/°C. With a realistic power loss density of 200 W/cm2, the deformation expected in the middle is reaching 46 microns. This confirming the possibility of implementing deformation sensing elements such as strain gauges with realistic copper design in the PCB for sensing the global deformation or the deformation in the vicinity of a single die. Similar deformation patterns would also occur for other examples of PCBs with different size and different numbers of levels.

Sensing elements that would be implemented in the case of the z axis expansion could be a strain gauge of the bending kind.

Other type of sensing elements such as piezo electric elements if made compatible with the embedding process could also be considered.

In the present disclosure, at least one sensing element 20, 21, 22 made with a strain gauge is embedded in a PCB to measure the deformation of the PCB during its life in order to monitor its health.

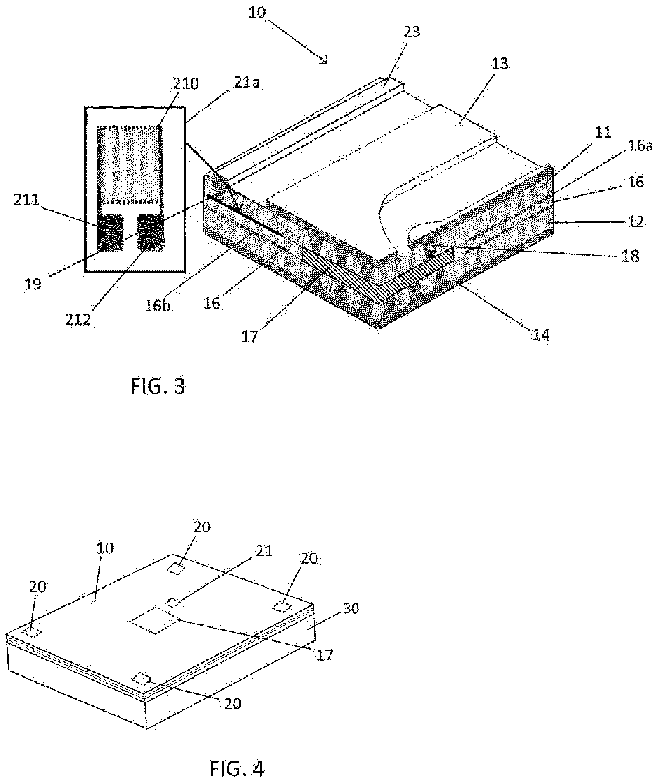

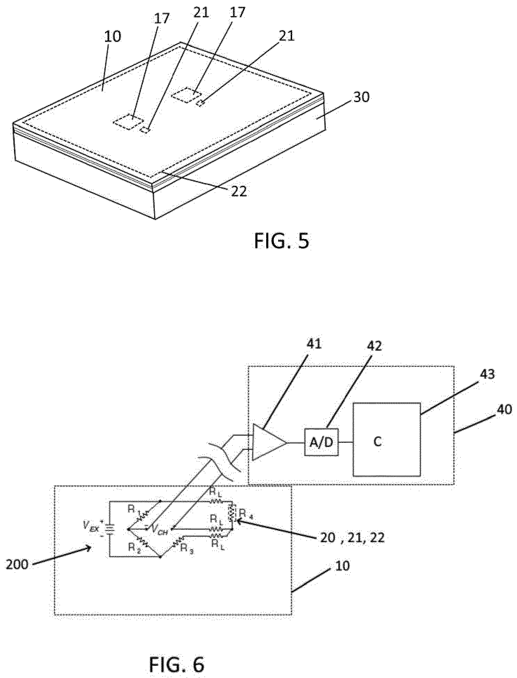

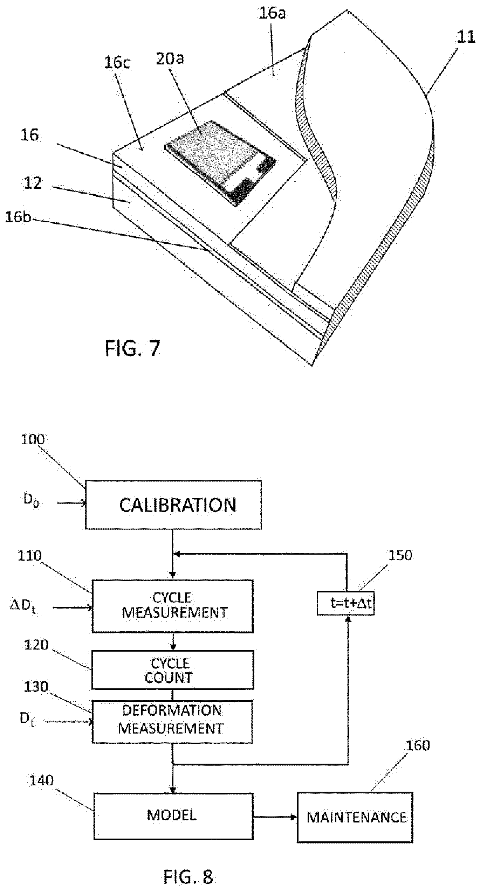

Different sensing elements can be located in the package in areas depending on the stress that can be monitored. The strain gauges can be embedded near a die as strain gauge 21 in figures 3, 4, 5 , or on a side of the PCB as strain gauge 20 in figures 4, strain gauge 22 in figure 5 or strain gauge 20a in figure 7.

Figure 2 shows a perspective cut view of a power module comprising a PCB comprising at least two outer layers, one upper layer 11 and a lower layer 12 provided with metallic tracks 13, 14, 15 and comprising a core layer 16 embedding one or more power semiconductor dies 17.

Connections between contact areas on the die 17 and tracks 13, 14, 15 on the outer layers are made with vias 18 drilled inside the outer layers and tracks and filled with conductive material such as copper or copper alloy.

In figure 3 a strain gauge 21a is embedded in said PCB to sense a mechanical stress in at least one axis in a three dimension coordinate system attached to the PCB. The strain gauge 21a in the vicinity the die 17 to detect mechanical deformation due to temperature cycling of said die.

In such example, the strain gauge is made with metallic tracks 210 structured in a copper layer 16a of the top side of said core layer 16 of said PCB. Contact pads 211, 212 of the strain gauge may be connected to a detection circuit with vias 19 and tracks 23. In such case however, the resistance of copper varying a lot with temperature, an important temperature compensation is needed. In addition, chemical etching pitch is limited by the copper thickness, and usually power application requires thick copper which is not compatible with thin pitch required by a sensitive strain gauge. For example, for a base copper thickness of 17 microns the minimum space in between track is set at 75 microns for our PCB manufacturer. This could be a clear limitation for fine sensitive sensor. In view of such limitations, a preferred design is to have strain gauges made of additional parts 20a as in figure 7. These parts may then be glued on the top or the bottom side of the core layer 16 in a copper free area 16c of said top or bottom side of said core layer during the lamination process of the PCB embedding the power die or the power dies. In such case, the connection of the gauge connecting pads is done in the same way than in figure 3 with vias and tracks with the same manufacturing process than the connections of the die or dies.

In this example the strain gauge is close to the die 17 but in other designs, at least one said strain gauges 20 may be located at a corner area of said PCB 10 such as in figure 4. In such a case, providing strain gauges located at all corners of the PCB allow to provide a measure of mechanical flatness defects of said PCB upon mounting of said PCB on a heatsink 30.

Another possibility is to have at least one of said strain gauge 22 designed as a frame in said PCB as in figure 5. Such a strain gauge in a perimeter area also providing a measure of mechanical flatness defects of said PCB upon mounting of said PCB on the heatsink.

In some cases, the strain gauge may comprise a resistance made of a pattern designed to form an indicator of the mechanical effort in the vicinity of the strain gauge, irrespective of the direction of such mechanical effort in said three dimension coordinate system attached to the PCB.

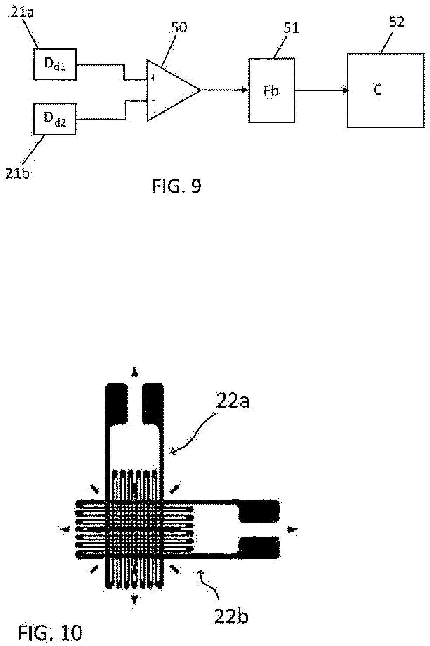

Figure 5 also shows a design where two power semiconductor dies 17 are present and each comprises a close strain gauge 21. This design allows, for a power module comprising two or more power semiconductors where the module comprises a strain gauge 21a, 21b for each die of power semiconductor to provide a comparison 50 of deformation at a locations of each of said dies and provide generation 51 of a feedback signal to a controller 52 driving gate drivers of said power semi-conductors and to provide an adaptative gate control or count of abnormal unbalanced cases in case of uneven deformations of the PCB at said locations as depicted in figure 9.

One or more strain gauges 20, 21, 22 may be incorporated in Wheatstone bridges 200 such as described in figure 6 for a quarter bridge strain gauge design with the strain gauge being resistor R4 and temperature compensation resistors R_{L}. The bridge has a voltage input V_{EX} which may be issued from the power module 10 or from a control module 40 and has a differential output V_{CH} connected to a controller chip 43 through an amplifier 41, and an analog to digital converter 42.

The bridge may be located on the power module PCB as shown in figure 6 but may also be located in a controller board and the connections of the strain gauges may be done through a flexible circuit board of a cable between the power module and the controller board.

In figure 10 is disclosed a strain gauge arrangement comprising two resistance patterns 22a, 22b oriented at 90° allow to form an indicator of the mechanical effort in the vicinity of the strain gauge, irrespective of the direction of such mechanical effort in said three dimension coordinate system attached to the PCB.

In such case, the resistance pattern 22a may be incorporated in layer 16a and the resistance pattern 22b may be incorporated in layer 16b of figure 3 where the copper layers are removed at the location where the strain gauges are incorporated.

The process for measuring stress on a power module PCB according to the present disclosure may comprise:
a. an initial measurement of a deformation D0 of the PCB in use during a calibration period 100 with said strain gauges to provide a calibration of an initial deformation range of said PCB,
b. in use measurements 110 of deformation cycles Cy of said PCB and counting 120 of said deformation cycles,
c. repeating 150 said in use measurements during operation of said power module.

The measurements may be repeated on a time to time basis such as every day, every week or on an operation time basis such as every hour or tenth of hours of operation of the module, may be continuous or may be repeated after a defined number of deformation cycles.

The process may also comprise measurement of plastic deformation 130 of said PCB through comparison of the minimum and maximum deformation of said PCB during operation of the power module with the initial deformation range. This may comprise selecting minimums and maximums of deformation to obtain a deformation range and its evolution in real time.

The process may comprise providing deformation measurement data to a lifetime model 140 of said PCB to provide lifetime model predictions for predictive maintenance 150.

### Industrial Applicability

The application of the deformation sensing elements may comprise manufacturing and production debugging: the sensing elements help identifying abnormal mechanical stress sustained during this first life step of the product. The sensing elements May also help checking the global deformation for the PCB after manufacturing and the good mechanical fastening during the production where the PCB is assembled within the final product (on the cooling device for example).

During the life of the PCB embedded power module, the sensing elements keep tracking the number and the amplitude of the thermal stress in the PCB. Those value keep tracks of abnormal stress and feed the end-of-life prognostic model through a communication line to a microcontroller. The maximum number of stress cycles is calculated, and a predictive maintenance plan can be planned accordingly before failure.

In order to get a homogeneous behaviour and consequently improve the global reliability of a power module of a converter or a power module with embedded power dies in other applications, deformation sensing elements may be used in a closed loop system which would track a null difference between dies of such a power module. This could be achieved through the gate drivers that would adapt the control to each of one. This technique called mechanical stress equalization improves the reliability by having a uniform repartition of the stress in the package. By providing a sensing element embedded near a die embedded in a PCB package, stress along could be monitored for better accuracy and fit with a stress mapping.

the solution is giving a key for monitoring the health of the package during the manufacturing steps, productions steps (mechanical assembly for example), during power module usage (power cycling, stress cycle counting) and for self-diagnostic and end of life prognostic (stress end of life rules related to a delamination aging process).

This disclosure is not limited to the described examples and the invention defined in the claim may encompasses every alternative that a person skilled in the art would envisage when reading this description. In example, one or more Wheatstone bridges may be configured as half bridges with temperature compensation strain gauge or as full Wheatstone bridges with four strain gauges to measure torsion in locations of the power module PCB.

## Claims

1. - Power module comprising a PCB comprising at least two outer layers (11, 12) provided with metallic tracks (13, 14, 15) and comprising a core layer (16) embedding one or more power semiconductor dies (17) **characterized in that** it comprises one or more deformation sensing elements (20, 21, 22) embedded in said PCB to sense a mechanical stress in at least one axis in a three dimension coordinate system attached to the PCB, one or more of said deformation sensing elements being located on the top or bottom side of said core layer.

2. - Power module according to claim 1 comprising at least one of said sensing elements (21) in the vicinity of said one or more power dies to detect mechanical deformation due to temperature cycling of said die.

3. - Power module according to claim 1 or 2 comprising at least one of said sensing elements (20) at in a corner area of said PCB (10) said sensing element being adapted to provide a measure of mechanical flatness defects of said PCB upon mounting of said PCB on a heatsink (30).

4. - Power module according to claim 1 or 2 comprising at least one of said sensing elements designed as a frame (22) in said PCB adapted to provide a measure of mechanical flatness defects of said PCB upon mounting of said PCB on a heatsink.

5. - Power module according to any one of the preceding claims wherein at least one (21a) of said sensing elements is made with metallic tracks (210) structured in a copper layer (16a, 16b) of the top or bottom side of said core layer (16) of said PCB.

6. - Power module according to any one of claims 1 to 4 wherein said one or more sensing elements are additional parts (20a) glued on the top or the bottom side of said core layer(16) in a copper free area (16c) of said top or bottom side of said core layer.

7. - Power module according to any one of the preceding claims comprising two or more power semiconductor dies (17) wherein said power module comprises a sensing element (21) for each of said power semiconductor dies.

8. - Power module according to any one of the preceding claims wherein at least one of said sensing elements comprise a strain gauge arrangement comprising resistance patterns (22a, 22b) designed to form an indicator of the mechanical effort in the vicinity of the strain gauge arrangement, irrespective of the direction of such mechanical effort in said three dimension coordinate system attached to the PCB.

9. - Power module according to any one of the preceding claims wherein said one or more sensing elements(20, 21, 22) have connections made of vias (19) and tracks (23) on said PCB.

10. - Power module according to any one of the preceding claims wherein said one or more sensing elements (20, 21, 22) are strain gauges incorporated in Wheatstone bridges (200) having a differential output V_{CH} connected to a controller chip (43) through an amplifier (41), and an analog to digital converter (42).

11. - Process for measuring stress on a power module PCB according to any one of the preceding claims comprising:
- an initial measurement of a deformation D₀ of the PCB in use during a calibration period (100) with said strain gauges to provide a calibration of an initial deformation range of said PCB,
- in use measurements (110) of deformation cycles Cy of said PCB and counting (120) of said deformation cycles,
- repeating (150) said in use measurements during operation of said power module.

12. - Process according to claim 11 comprising measurement of plastic deformation (130) of said PCB through comparison of the minimum and maximum deformation of said PCB during operation of the power module with the initial deformation range.

13. - Process according to claim 11 or 12 for a power module comprising two or more power semiconductors wherein said power module comprises a strain gauge (21a, 21b) for each die of said power semiconductors, wherein said process comprises a comparison (50) of deformation at a locations of each of said dies and comprises a generation (51) of a feedback signal to a controller (52) driving gate drivers of said power semi-conductors to provide an adaptative gate control or count of abnormal unbalanced cases in case of uneven deformations of the PCB at said locations.

14. - Process according to any one of claims 11 to 13 comprising providing deformation measurement data to a lifetime model (140) of said PCB to provide lifetime model predictions for predictive maintenance (150).

## Patentansprüche

1. Leistungsmodul, umfassend eine PCB, umfassend wenigstens zwei äußere Lagen (11, 12), welche mit metallischen Bahnen (13, 14, 15) bereitgestellt sind und eine Kernlage (16) umfasst, welche eine oder mehrere Leistungshalbleitermatrizen (17) einbaut, **dadurch gekennzeichnet, dass** es wenigstens eine oder mehrere Deformationsmesselemente (20, 21, 22) umfasst, welche in der PCB eingebaut sind, um eine mechanische Beanspruchung in wenigstens einer Achse in einem dreidimensionalen Koordinatensystem zu messen, welches an der PCB befestigt ist, wobei eine oder mehrere der Deformationsmesselemente an der Ober- oder Unterseite der Kernlage angeordnet sind.

2. Leistungsmodul nach Anspruch 1, umfassend wenigstens eines der Messelemente (21) in der Umgebung der einen oder mehreren Leistungsmatrizen, um eine mechanische Deformation aufgrund eines Temperaturwechsels der Matrize zu detektieren.

3. Leistungsmodul nach Anspruch 1 oder 2, umfassend wenigstens eines der Messelemente (20) an einem Eckbereich der PCB (10), wobei das Messelement dazu eingerichtet ist, ein Maß von mechanischen Ebenheitsfehlern der PCB auf ein Befestigen der PCB an einer Wärmesenke (30) hin bereitzustellen.

4. Leistungsmodul nach Anspruch 1 oder 2, umfassend wenigstens eines der Messelemente, welches als ein Rahmen (22) designt ist, in der PCB, welches dazu eingerichtet ist, ein Maß von mechanischen Ebenheitsfehlern der PCB auf ein Befestigen der PCB an einer Wärmesenke hin bereitzustellen.

5. Leistungsmodul nach einem der vorhergehenden Ansprüche, wobei wenigstens eines (21a) der Messelemente mit metallischen Bahnen (210) hergestellt ist, welche in einer Kupferlage (16a, 16b) der Ober- oder Unterseite der Kernlage (16) der PCB strukturiert sind.

6. Leistungsmodul nach einem der Ansprüche 1 bis 4, wobei das eine oder die mehreren Messelemente zusätzliche Teile (20a) sind, welche an der Ober- oder Unterseite der Kernlage (16) in einem kupferfreien Bereich (16c) der Ober- oder Unterseite der Kernlage geklebt sind.

7. Leistungsmodul nach einem der vorhergehenden Ansprüche, umfassend zwei oder mehr Leistungshalbleitermatrizen (17), wobei das Leistungsmodul ein Messelement (21) für jede der Leistungshalbleitermatrizen umfasst.

8. Leistungsmodul nach einem der vorhergehenden Ansprüche, wobei wenigstens eines der Messelemente eine Dehnungsmessstreifen-Anordnung umfasst, welche Resistenzmuster (22a, 22b) umfassen, welche designt sind, um eine Anzeige der mechanischen Belastung in der Nähe der Dehnungsmessstreifen-Anordnung zu bilden, unabhängig von der Richtung einer solchen mechanischen Belastung in dem dreidimensionalen Koordinatensystem, welches an die PCB befestigt ist.

9. Leistungsmodul nach einem der vorhergehenden Ansprüche, wobei das eine oder die mehreren Messelemente (20, 21, 22) Verbindungen aufweisen, welche aus Vias (19) und Bahnen (23) an der PCB hergestellt sind.

10. Leistungsmodul nach einem der vorhergehenden Ansprüche, wobei das eine oder die mehreren Messelemente (20, 21, 22) Dehnungsmessstreifen sind, welche in Wheatstone-Brücken (200) eingebaut sind, welche einen differentiellen Ausgang V_{CH} aufweisen, welcher mit einem Steuerungschip (43) durch einen Verstärker (41) und einen Analog-Digital-Wandler (42) verbunden ist.

11. Verfahren zum Messen einer Beanspruchung einer Leistungsmodul-PCB nach einem der vorhergehenden Ansprüche, umfassend:
eine initiale Messung einer Deformation D₀ der verwendeten PCB während einer Kalibierperiode (100) mit den Dehnungsmessstreifen, um eine Kalibrierung eines initialen Deformationsbereichs der PCB bereitzustellen,
Verwendungsmessungen (110) von Deformationszyklen Cy der PCB und Zählen (120) der Deformationszyklen,
Wiederholen (150) der Verwendungsmessungen während eines Betriebs des Leistungsmoduls.

12. Verfahren nach Anspruch 11, umfassend eine Messung einer plastischen Deformation (130) der PCB durch einen Vergleich der minimalen und maximalen Deformation der PCB während des Betriebs des Leistungsmoduls mit dem initialen Deformationsbereich.

13. Verfahren nach Anspruch 11 oder 12 für ein Leistungsmodul, umfassend zwei oder mehr Halbleiter, wobei das Leistungsmodul einen Dehnungsmessstreifen (21a, 21b) für jede Matrize der Leistungshalbleiter umfasst, wobei das Verfahren einen Vergleich (50) einer Deformation an Positionen von jeder der Matrizen umfasst und eine Generierung (51) eines Feedbacksignals an eine Steuerungseinheit (52) umfasst, welche Gate-Treiber der Leistungshalbleiter antreibt, um eine adaptive Gate-Steuerung oder ein Zählen von abnormalen unausgeglichenen Fällen bereitstellt, im Fall von unregelmäßigen Deformationen der PCB an den Positionen.

14. Verfahren nach einem der Ansprüche 11 bis 13, umfassend ein Bereitstellen von Deformationsmessdaten an ein Betriebsdauermodell (140) der PCB, um Betriebsdauermodell-Vorhersagen für eine vorhersagende Wartung (150) bereitzustellen.

## Revendications

1. Module de puissance comprenant une carte de circuit imprimé comprenant au moins deux couches extérieures (11, 12) munies de pistes métalliques (13, 14, 15) et comprenant une couche centrale (16) intégrant une ou plusieurs puces de semi-conducteurs de puissance (17) **caractérisé en ce qu'**il comprend un ou plusieurs éléments de détection de déformation (20, 21, 22) intégrés dans ladite carte de circuit imprimé pour détecter une contrainte mécanique dans au moins un axe dans un système de coordonnées tridimensionnelles fixé à la carte de circuit imprimé, un ou plusieurs desdits éléments de détection de déformation étant situés sur le côté supérieur ou inférieur de ladite couche centrale.

2. Module de puissance selon la revendication 1 comprenant au moins un desdits éléments de détection (21) au voisinage desdites une ou plusieurs puces de puissance pour détecter une déformation mécanique due à des cycles de température de ladite puce.

3. Module de puissance selon la revendication 1 ou 2 comprenant au moins un desdits éléments de détection (20) dans une zone d'angle de ladite carte de circuit imprimé (10), ledit élément de détection étant adapté pour fournir une mesure des défauts de planéité mécanique de ladite carte de circuit imprimé lors du montage de ladite carte de circuit imprimé sur un radiateur (30).

4. Module de puissance selon la revendication 1 ou 2 comprenant au moins l'un desdits éléments de détection conçus comme un cadre (22) dans ladite carte de circuits imprimés adapté pour fournir une mesure des défauts de planéité mécanique de ladite carte de circuit imprimé lors du montage de ladite carte de circuits imprimés sur un radiateur.

5. Module de puissance selon l'une quelconque des revendications précédentes dans lequel au moins un (21a) desdits éléments de détection est réalisé avec des pistes métalliques (210) structurées dans une couche de cuivre (16a, 16b) du côté supérieur ou inférieur de ladite couche centrale (16) de ladite carte de circuit imprimé.

6. Module de puissance selon l'une quelconque des revendications 1 à 4 dans lequel lesdits un ou plusieurs éléments de détection sont des pièces supplémentaires (20a) collées sur le côté supérieur ou le côté inférieur de ladite couche centrale (16) dans une zone (16c) exempte de cuivre dudit côté supérieur ou côté inférieur de ladite couche centrale.

7. Module de puissance selon l'une quelconque des revendications précédentes comprenant deux puces de semi-conducteurs de puissance (17) ou plus dans lequel ledit module de puissance comprend un élément de détection (21) pour chacune desdites puces de semi-conducteurs de puissance.

8. Module de puissance selon l'une quelconque des revendications précédentes dans lequel au moins l'un desdits éléments de détection comprend un agencement de jauge de contrainte comprenant des motifs de résistance (22a, 22b) conçus pour former un indicateur de l'effort mécanique à proximité de l'agencement de jauge de contrainte, quelle que soit la direction de cet effort mécanique dans ledit système de coordonnées tridimensionnelles fixé à la carte de circuit imprimé.

9. Module de puissance selon l'une quelconque des revendications précédentes dans lequel lesdits un ou plusieurs éléments de détection (20, 21, 22) ont des connexions composées de vias (19) et de pistes (23) sur ladite carte de circuit imprimé.

10. Module de puissance selon l'une quelconque des revendications précédentes dans lequel lesdits un ou plusieurs éléments de détection (20, 21, 22) sont des jauges de contrainte incorporées dans des ponts de Wheatstone (200) ayant une sortie différentielle V_{CH} connectée à une puce de contrôleur (43) par l'intermédiaire d'un amplificateur (41), et un convertisseur analogique-numérique (42).

11. Procédé pour mesurer une contrainte sur une carte de circuits imprimés de module de puissance selon l'une quelconque des revendications précédentes comprenant :
- une mesure initiale d'une déformation D₀ de la carte de circuit imprimé lors d'une utilisation pendant une période d'étalonnage (100) avec lesdites jauges de contrainte pour fournir un étalonnage d'une plage de déformation initiale de ladite carte de circuit imprimé,
- lors d'une utilisation des mesures (110) de cycles de déformation Cy de ladite carte de circuit imprimé et le comptage (120) desdits cycles de déformation,
- la répétition (150) desdites mesures lors d'une utilisation pendant le fonctionnement dudit module de puissance.

12. Procédé selon la revendication 11 comprenant la mesure de la déformation plastique (130) de ladite carte de circuit imprimé par comparaison de la déformation minimale et maximale de ladite carte de circuit imprimé pendant le fonctionnement du module de puissance avec la plage de déformation initiale.

13. Procédé selon la revendication 11 ou 12 pour un module de puissance comprenant deux semi-conducteurs de puissance ou plus dans lequel ledit module de puissance comprend une jauge de contrainte (21a, 21b) pour chaque puce desdits semi-conducteurs de puissance, dans lequel ledit procédé comprend une comparaison (50) de déformation à un emplacement de chacune desdites puces et comprend une génération (51) d'un signal de retour vers un dispositif de commande (52) pilotant des pilotes de grille desdits semi-conducteurs de puissance pour fournir une commande de grille adaptative ou un décompte de cas déséquilibrés anormaux en cas de déformations irrégulières de la carte de circuit imprimé auxdits emplacements.

14. Procédé selon l'une quelconque des revendications 11 à 13 comprenant la fourniture de données de mesure de déformation à un modèle de durée de vie (140) de ladite carte de circuit imprimé pour fournir des prédictions de modèle de durée de vie pour la maintenance prédictive (150).
